Europäisches Patentamt

European Patent Office

Office européen des brevets

(11) Publication number: **0 269 146**
**A2**

(12) **EUROPEAN PATENT APPLICATION**

(21) Application number: **87202007.8**

(22) Date of filing: **19.10.87**

(51) Int. Cl.⁴: **H01F 7/20** , G01N 24/06

(30) Priority: **27.10.86 NL 8602688**

(43) Date of publication of application:
**01.06.88 Bulletin 88/22**

(84) Designated Contracting States:
**AT BE CH DE FR GB IT LI NL**

(71) Applicant: **Smit Transformatoren B.V.**
**Groenestraat 336**
**NL-6531 JC Nijmegen(NL)**

(72) Inventor: **Ten Zweege, Johan Gerhardus**
**Wedesteinbroek 10-28**
**NL-6546 RC Nijmegen(NL)**
Inventor: **Mertens, Hans Victor**
**Talmastraat 22**
**NL-6592 EP Dieren(NL)**

(74) Representative: **Hoijtink, Reinoud et al**
**OCTROOIBUREAU ARNOLD & SIEDSMA**
**Sweelinckplein 1**
**NL-2517 GK Den Haag(NL)**

(54) **Apparatus for mounting coils.**

(57) The present invention concerns an apparatus for the mounting of at least one open flat coil on a cilindrical support structure. Generally such coils are used as so called gradient coils in apparatusses for nuclear magnetic resonance. To avoid possible movement of the coils, causing a disturbing sound the open saddle shaped coils are provided with clamping plates (14, 20) in their apertures. Each clamping plate is connected to a pair of strips (15, 21) extending to the outer sides of the coil. The coils are wrapped around the support structure, and their ends are joined. Usually the strips mount two coils located on opposite sides of the support structure. According to a preferred embodiment two layers of coils (5, 6) mutually shifted over 90° are mounted, wherein the strips (15) of the first layer extend over the coils (6) of the second layer, and wherein the clamping plates (14) of the first layer are locked up by the coils (6) of the second layer and wherein the clamping plates (20) of the second layer are locked up by the strips (15) of the first layer.

FIG. 4

## Apparatus for mounting coils.

The present invention relates to an apparatus for the mounting of at least one open flat coil on a cilindrical support structure.

For instance such open flat coils are used in apparatusses for the examination of bodies by means of nuclear magnetic resonance. Generally in such apparatusses for examination a static magnetic main field generated by a magnet is used, in which magnetic main field a set of so called gradient coils is located. This set of gradient coils is often mounted on a cilindrical support structure. Within the cilindrical support structure a third set of coils, the so called RF coils are mounted on another support structure and during the examination the body to be examined is located within said support structure.

The present invention relates in particular to the mounting of the gradient coils. Generally the gradient coils are supplied with rapidly switched DC-currents. The gradient coils, through which a current flows are subjected to major rapidly varying forces caused by the magnetic main field. This implies that these coils will be subjected to an oscillating movement, causing a disturbing sound.

The aim of the present invention is to provide a mounting apparatus in which the coils are mounted on the cilindrical support structure wherein the coils are subjected to such a limited movement that the volume of sound thus generated is reduced considerably.

Another aim is to provide such an apparatus, which can withstand major forces acting on the coils.

A further aim of the present invention is to provide such an apparatus which is relatively simple, which has only a limited extension in the radial direction, and wherein the coils are mounted upon the support structure in a relatively simple manner.

These aims are reached by a pair of clamping plates located within each coil, in which each clamping plate is connected with a pulling element, and wherein adjacent pulling elements are connected through a tensioning element.

This mounting apparatus applies a tensioning force to the coils, causing the coils to be clamped stiffly on the support structure, so that the coils can only be subjected to a movement with a very limited amplitude. The volume of sound generated is thus limited considerably.

Subsequently the present invention will be elucidated with the help of embodiments depicted in the accompanying drawings showing:

Figure 1: a schematic perspective view of an apparatus for the examination of a body by means of nuclear magnetic resonance;

Figure 2: a schematic perspective view of a support structure, onto which gradient coils are mounted;

Figure 3: a cross-sectional view of the location of gradient coils on the cilindrical support structure;

Figure 4: a perspective view of a part of the support structure with a set of gradient coils mounted thereon; and

Figure 5: a detailed perspective view, partially broken away, of the mounting apparatus according to the present invention.

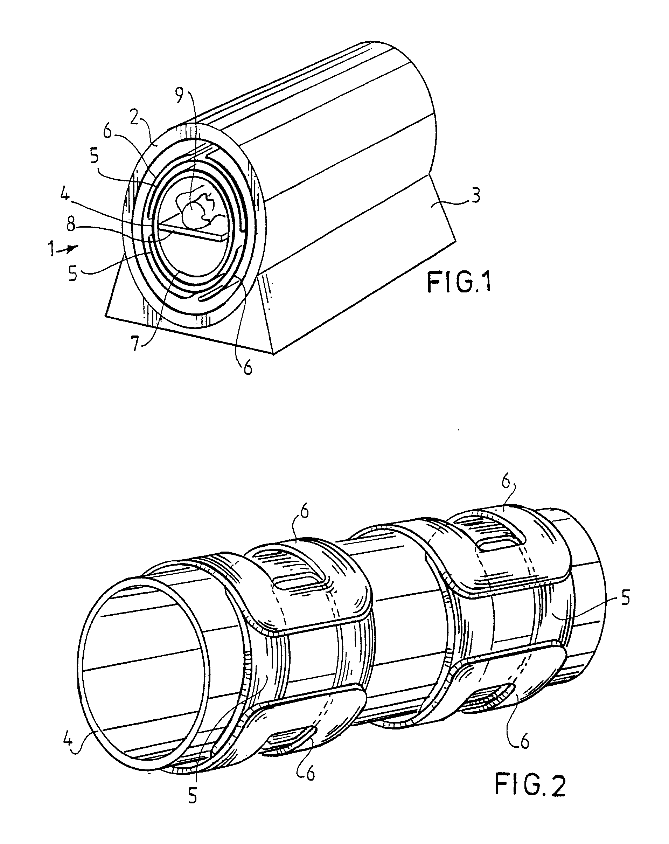

In figure 1 an apparatus for examination by means of nuclear magnetic resonance is - schematically shown, in which apparatus the magnetic main field is generated by a super conducting magnet. This apparatus 1 comprises a cryostat 2, wherein super conducting coils, not depicted in the drawings are located. The cryostat 2 is supported by a supporting plate 3. Within the cryostat 2 a cilindrical support structure 4 is mounted.

A set of saddle shaped X-coils 5 is mounted on the support structure 4, which coils are located to generate a magnetic field during excitation of which the axis is vertical. Shifted over an angle of 90° relative to the X-coils 5 a set of Y-coils 6 is mounted . These Y-coils 6 generate during excitation a magnetic field, the axis thereof extending horizontally. Finally a set of Z-coils, not depicted in figure 1, is mounted on the support structure 4, which coils during excitation generate a magnetic field with an axis parallel to the axis of the cilinder.

Within the cilindrical support structure 4 a second cilindrical support structure 7 is provided, whereon the so called RF coils (not depicted) are mounted. Finally a table 8, onto which the body 9 to be examined can be located is provided within the support structure 7 for the RF-coils.

Figure 2 shows schematically the location of the X-coils 5 and the Y-coils 6 on the cilindrical support structure 4. The cilindrical support structure 4 is manufactured from a non-magnetic material, like epoxy resin reinforced with glass fiber.

The saddle shaped coils 5 are mounted adjacent to the surface of the cilinder. The Y-coils 6 are mounted on the layer formed by the X-coils and wherein the Y-coils are supported by separate support structures in the locations, wherein the Y-coils are not supported by the X-coils.

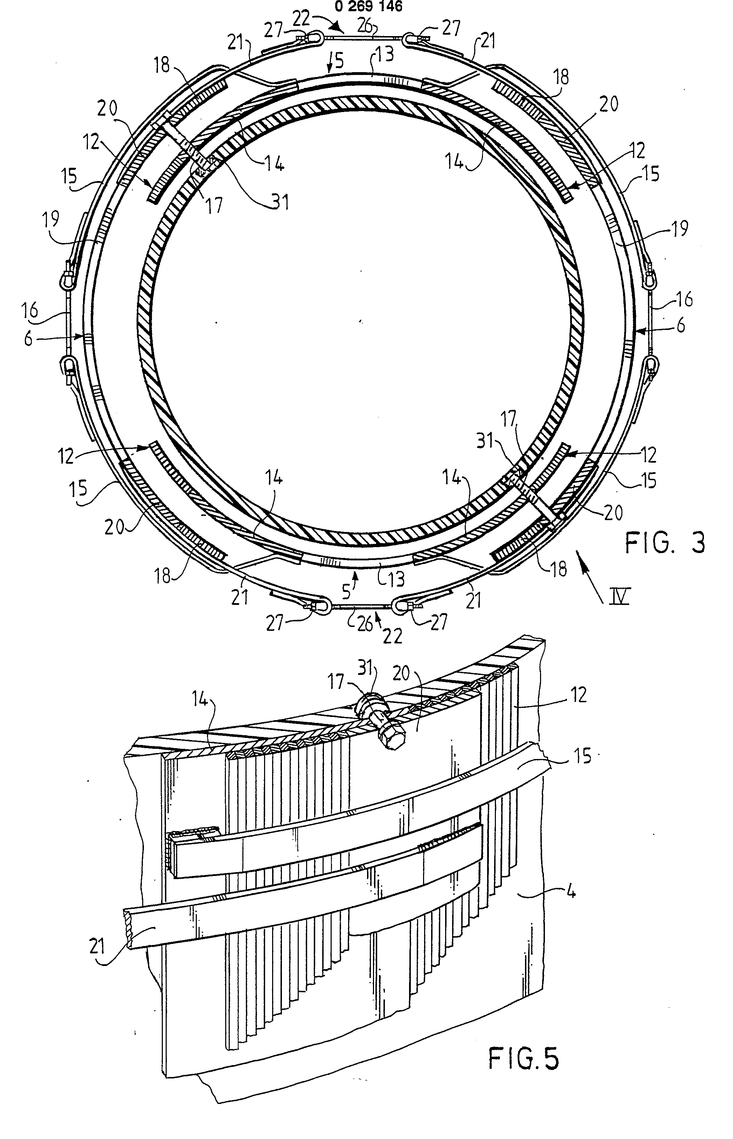

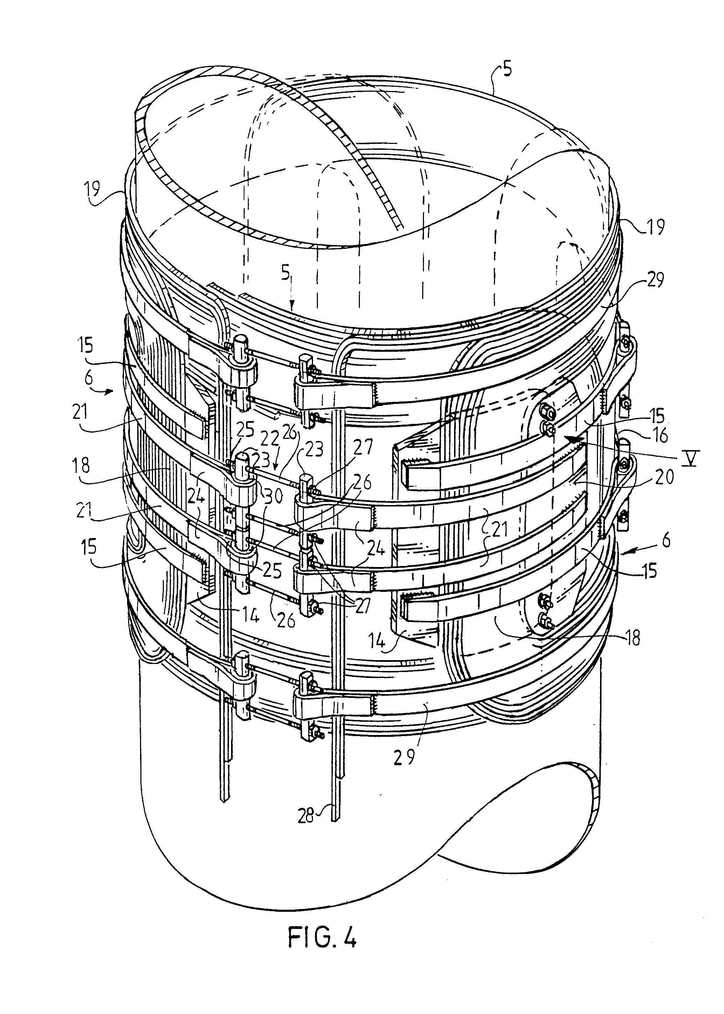

Subsequently the mounting of the coils on the support structure 4 will be described with the help of figures 3 and 4. Each of the X-coils 5 has a longitudinal annular shape and comprises two coil sides 13 and two coil heads 12 together surrounding a coil aperture. In the aperture of each coil adjacent to the coil head 12 large clamping plates 14 are located. To each of the clamping plates 14 two pulling strips 15 are attached.

If only the X-coils whould have to be mounted the ends of the pulling strips 15 concerned could have been connected through tensioning elements 16. By tensioning the tensioning elements 16 the X-coils 5 would be mounted securely on the support structure 4. To fixate the location of the coils one of each pair of clamping plates 14 could have been connected to the support structure 4 by means of a bolt 17.

In the application of the present invention in an apparatus for nuclear magnetic resonance a pair of Y-coils 6, shifted over an angle of 90° relative to the X-coils 5 is necessary apart from the pair of X-coils 5. These Y-coils 6 are just as well mounted on the cilindrical support structure in the same way. The pulling strips 15 for the X-coil are for the time being not connected to eachother and initially the Y-coils 6 are applied such that the pulling strips extend over the coil heads 18 of the X-coils 6. Small clamping plates 20 for the Y-coils 6 are located adjacent to the coil heads 18 of the Y-coils 6. Pulling strips 21 for the Y-coils are attached to said small clamping plates 20. Hereafter both the pulling strips 15 for the X-coils and the pulling strips 21 for the Y-coils can be connected by means of tensioning elements 16 and tensioning elements 22, respectively.

As the clamping plates 14, 20 are locked up by the pulling strips 15 and 21 the danger is avoided that the clamping plates 14, 20 will deflect outwardly as a cause of the pulling force exerted by the tensioning elements 16, 22. Thus the pulling strips 15 lock up the clamping plates 20 and the pulling strips 21 lock up the clamping plates 14.

Both the X-coils 5 as well as the Y-coils 6 are mounted onto the surface of the cilindrical support structure 4 by both tensioning elements, such that, when this support structure is applied in an apparatus for examination by means of nuclear magnetic resonance, during excitation the coils will generate a sound volume, which is reduced considerably.

In the embodiment described above the subject is the mounting of a pair of coils. It will be obvious that the apparatus according to the present invention is also fit for the mounting of a single coil, and that it is also fit for the mounting of a multilayer coil. It is noted that the apparatus is not limited to a rectangular coil but is also suitable for the mounting of e.g. a round or an oval shaped coil.

Figure 4 shows a perspective view of a support structure, whereon X-and Y-coils are mounted with an apparatus according to the present invention. The X-coil 5 is mounted on the support structure 4, and in the coil aperture of the X-coil 5 a pair of large clamping plates 14 is located. One of each clamping plates 14 is provided with holes, through which a bolt 17 is inserted. Two pulling strips 15 are attached to each of the clamping plates 14, which pulling strips are attached to pulling strips 15, not depicted, and which belong to a coil 5, not depicted, and located unto the back side of the support structure 4. The pulling strips 15 are all guided over the coil heads 18 of the X-coil 6. Y-coils 6 are mounted in a position over the X-coils 5, and shifted over a angle of 90° relative to the position of the X-coils 5. Small clamping plates 20 are located in the coil apertures of these Y-coils adjacent to the coil heads. To each of said clamping plates 20 two pulling strips 21 are attached, of which the relevant are connected to eachother through a tensioning element 22.

In the embodiment shown each of the tensioning elements 16 comprises two bars 23, over each of which a free end of the relevant pulling strip 15, 21 respectively is folded. After folding the free ends are attached to the strip itself, so that a loop 25 is developed, through which the relevant bar 23 extends. Between one of the bars 23 of each tensioning element and the relevant pulling strip an isolating sleeve is provided. This isolating sleeve avoids that the field generated by the coils generates currents in the pulling strip. Both bars 23 are connected to eachother by means of two studs 26, which extend through apertures provided in the bars 23. Nuts 27 are screwed upon the ends of the studs 26. By tightening these nuts the pulling strips can be tensioned.

The mounting apparatus according to the present invention provides a good fixation of the coils on the support structure but it is also important that the branches of the coils, like the branch 28 is pushed firmly against the support structure. For that purpose extra pulling strips 29 are provided for every set of coils, pushing the branches 28 of the coils against the support structure. Both ends of each pulling strip 29 are connected again through tensioning elements.

In figure 5 the fixation of a large clamping plate 14 and a small clamping plate 20 located therein is showed in more detail. The small clamping plate 20 extends at least partially over a part of the clamping plate 14, so that both clamping plates at the same time can be connected to the support structure 4 by a connection, comprising a bolt 17 and a sleeve 31 screwed into the support structure 4.

The clamping plates 14, 20 located on the other side of the support structure 4 are fixed in the same way, while the other clamping plates 14, 20 are not connected directly to the support structure. Thus only one coil head of each coil 5, 6 is fixed, while the other coil head is free, so that its location can be determined by the tensioning element. This provides both a good fixation of locations and a good mounting of the coils.

As the mounting apparatus according to the present invention has only a limited extension in the radial direction a compact set of gradient coils is provided, of which the diameter exceeds the outer diameter of the outer layer of coils by a limited extent only.

## Claims

1. Apparatus for mounting at least one open flat coil on a cilindrical support structure, characterized by a pair of clamping plates located in each coil aperture, wherein each clamping plate is connected to a pulling element extending to the outer side of the coil concerned, and wherein adjacent pulling elements are connected through a tensioning element.

2. Apparatus according to claim 1, characterized in that the cilindrical support structure has the shape of a circular cilinder, and that two substantially identical saddle shaped coils, mutually shifted of an angle of 180° are mounted thereon.

3. Apparatus according to claim 2, characterized in that the coils are made up by gradient coils of an apparatus for the examination of a body by means of nuclear magnetic resonance.

4. Apparatus according to claim 3, characterized in that a second pair of coils is located over the first pair of coils, and that the second pair of coils is shifted over an angle of 90° relative to the first pair of coils.

5. Apparatus according to claim 4, characterized in that the addition of the angles conforming the coil apertures is greater than 360°, and that at least one of the clamping plates of the first pair of coils and the clamping plate of the second pair of coils mounted thereon are both rigidly connected to the support structure.

6. Apparatus according to claim 5, characterized in that two clamping plates mutually shifted over an angle of 180° of the first pair of coils and both clamping plates of the first pair of coils mounted thereon are all rigidly connected to the support structure.

7. Apparatus according to claim 4, 5, or 6, characterized in that the pulling elements of the first pair of coils are guided over the windings of the second pair of coils.

8. Apparatus according to one of the preceeding claims, characterized by pulling elements extending around the coils.

9. Apparatus according to one of the preceeding claims, characterized in that the pulling elements are manufactured of iron strip.

10. Apparatus according to claim 9, characterized in that the tensioning elements electrically isolate the pulling elements.

11. Apparatus according to one of the preceeding claims, characterized in that each tensioning element comprises two bodies connected to the relevant pulling elements, which bodies are mutually connected to at least one stud.

12. Apparatus according to claim 11, characterized in that between one of the two bodies and the pulling element connected thereto an isolating sleeve has been provided.

13. Apparatus according to one of the preceeding claims, characterized in that a second coil surrounding the coil has been provided wherein the space between the coils has been filled in by suitable material.

14. Apparatus according to one of the preceeding claims, characterized in that the coil comprises more than one layer.

FIG.1

FIG.2

**0 269 146**

FIG. 3

FIG. 5

FIG. 4